# EUROPÄISCHE PATENTSCHRIFT

(11) **EP 2 188 425 B1**
(45) Veröffentlichungstag und Bekanntmachung des Hinweises auf die Patenterteilung: **18.05.2011**
(21) Anmeldenummer: 08801821.3
(22) Anmeldetag: 03.09.2008
(51) Int. Cl.: D04B 15/78

(54) **BIEGEWANDLERELEMENT SOWIE BIEGEWANDLERMODUL**
BENDING ACTUATOR ELEMENT AND BENDING ACTUATOR MODULE
ÉLÉMENT CONVERTISSEUR DE FLEXION ET MODULE CONVERTISSEUR DE FLEXION

(30) Priorität: 03.09.2007 DE 102007041636
(43) Veröffentlichungstag der Anmeldung: 26.05.2010
(73) Patentinhaber: Argillon GmbH, 96257 Redwitz (DE)
(72) Erfinder: RÜTTEL, Martin, 96271 Grub am Forst (DE); KLUMP, Stefan, 96215 Lichtenfels (DE); GÜNTHER, Jürgen, 96342 Stockheim (DE); KREMER, Hubert, 96349 Steinwiesen (DE); SCHLEICHER, Jürgen, 96523 Steinach (DE)
(74) Vertreter: FDST Patentanwälte
(86) Internationale Anmeldenummer: PCT/EP2008/007193
(87) Internationale Veröffentlichungsnummer: WO 2009/030468

(56) Entgegenhaltungen:
- EP-A- 0 210 790
- EP-A- 1 080 503
- DE-A1- 19 706 755

## Beschreibung

Die Erfindung betrifft ein Biegewandlerelement mit einem Biegewandler, der einen flachen Tragkörper und eine darauf auf mindestens einer Seite aufgebrachte piezoelektrisch aktive Beschichtung umfasst. Die Erfindung betrifft weiter ein Biegewandlermodul, in welchem eine Mehrzahl von Biegewandlerelementen zusammengefasst ist.

Ein Biegewandler, wie für das Biegewandlerelement eingangs genannt, dient vorrangig zur Ausnutzung des indirekten oder reziproken piezoelektrischen Effekts, das heißt der Umwandlung von elektrischer in mechanische Energie. Gleichwohl eignet sich ein piezoelektrischer Biegewandler auch dazu, mechanische in elektrische Energie umzuwandeln. Hierbei wird der direkte piezoelektrische Effekt ausgenutzt.

Für einen piezoelektrischen Biegewandler gibt es eine Vielzahl von technischen Anwendungen. Solche Anwendungen sind zum Beispiel als ein piezoelektrischer Druckkopf für einen Tintenstrahldrucker, als ein Sensor für die Beschleunigungs- oder Druckmessung, als ein Stellelement für die Weitergabe der Musterinformation in einer Web-, Wirk- oder Strickmaschine und als ein Stellelement in einer Braille-Zeile in einem Lesegerät für Blinde, in einem Pneumatikventil, in einem schreibenden Messgerät oder in einem berührungslosen Oberflächen-Messinstrument. Auch kann ein piezoelektrischer Biegewandler als Generator zur Bereitstellung elektrischer Energie eingesetzt werden. Ein solches Anwendungsgebiet ist beispielsweise die Erzeugung von Energie für eine Messelektronik, die beispielsweise auf beweglichen oder rotierenden Teilen angeordnet ist, und die insofern durch Kabel nur aufwändig kontaktierbar ist.

Zum Betrieb des genannten piezoelektrischen Biegewandlers ist die piezoelektrisch aktive Beschichtung in der Regel flächig mit Elektroden, auch Kontaktflächen genannt, belegt. Insbesondere kann im Falle eines leitfähigen Tragkörpers auch der Tragkörper selbst als eine derartige Kontaktfläche wirken. Wird eine elektrische Spannung an die Kontaktflächen angelegt, so führt dies je nach Polung zu einer Kontraktion oder einer Expansion der zwischen den Kontaktflächen angeordneten piezoelektrischen Beschichtung. Infolge dessen verbiegt sich der gesamte Biegewandler oder es wird bei einem festgehaltenen Festende des Biegewandlers das Losende definiert ausgelenkt.

Umgekehrt wird eine Spannung zwischen den Kontaktflächen oder Elektroden der piezoelektrischen Beschichtung erzeugt, wenn der Biegewandler durch einen mechanischen Einfluss gegenüber seiner Ruheposition verbogen wird. Dadurch wird die piezoelektrische Beschichtung kontrahiert oder ausgedehnt, wodurch sich aufgrund des direkten piezoelektrischen Effekts eine Spannung aufbaut.

Ein Biegewandler der genannten Art ist beispielsweise aus der DE 195 20 796 A1, der DE 40 25 436 A1 oder der DE 196 20 826 B1 bekannt.

Ein Biegewandlermodul der eingangs genannten Art mit einer Mehrzahl von piezoelektrischen Biegewandlern wird dazu verwendet, ein elektronisches Informationssignal in ein mechanisch abtastbares Informationssignal umzuwandeln. Beispielsweise wird ein Biegewandlermodul mit einer Vielzahl von parallel angeordneten elektrischen Biegewandlern zum Ansteuern der Nadeln oder der Maschen bildenden Elemente einer Web-, Wirk- oder Strickmaschine verwendet. Zur Musterbildung in der von einer Textilmaschine erzeugten Ware wird dabei die Information, ob eine Masche gebildet wird oder nicht, über eine mechanische Abtastung der Auslenkung des entsprechenden piezoelektrischen Biegewandlers erhalten. Insbesondere eignet sich ein solches Biegewandlermodul für den Einsatz in einer Jacquard-Maschine. Ein solches Biegewandlermodul ist beispielsweise aus der US 3,961,501 A oder der EP 0 210 790 A2 bekannt. Auch in der DE 197 06 755.7 A1 wird ein solches Biegewandlermodul vorgeschlagen.

Die piezoelektrisch aktive Beschichtung besteht in der Regel aus einer Piezokeramik. Eine Piezokeramik erlaubt nämlich über ihre Zusammensetzung eine An passung an unterschiedliche Anforderungen, welche beispielsweise hinsichtlich des Wärmeausdehnungkoeffizienten, der Größe des piezoelektrischen Effekts oder aber auch hinsichtlich der Flexibilität gestellt werden. Insbesondere sind bestimmte Oxidkeramiken, zum Beispiel auf der Basis Blei-Zirkonat-Titan, bekannt, die hervorragende Eigenschaften aufweisen.

Nachteiligerweise zeigt eine piezoelektrisch aktive Beschichtung und insbesondere eine Piezokeramik eine hohe Bruchempfindlichkeit. Insbesondere bei einem Biegewandler, bei dem die piezoelektrisch aktive Beschichtung auf einem flexiblen Tragkörper aufgebracht ist, muss bei der Montage, bei einem Austausch oder generell beim Transport äußerst sorgfältig vorgegangen werden. Es muss darauf geachtet werden, dass der Biegewandler mechanisch nicht über eine kritische Grenze hinaus verbogen wird. In einem Biegewandlermodul sind zudem viele Biegewandler auf kleinem Raum zusammengefasst; zusätzlich ist eine Ausrichtung des Biegewandlers bei dessen Einsetzen in das Modul erforderlich. Trotz sorgfältigen Vorgehens führt dennoch die hohe Bruchempfindlichkeit beim Einsetzen und Ausrichten der Biegewandler zu einer unerwünscht hohen Beschädigungsquote.

Es ist Aufgabe der Erfindung, ein Biegewandlerelement und ein Biegewandlermodul der eingangs genannten Art anzugeben, bei welchen die Beschädigungsquote der Biegewandler bei der Montage, beim Transport oder beim Ausrichten gegenüber den bekannten Ausführungsformen des Standes der Technik herabgesetzt ist.

Die erstgenannte Aufgabe wird erfindungsgemäß gelöst durch ein Biegewandlerelement mit einem Schutzgehäuse und mit einem darin angeordneten Biegewandler, der einen flachen Tragkörper und eine darauf auf mindestens einer Seite aufgebrachte piezoelektrisch aktive Beschichtung umfasst, wobei der Biegewandler im Wesentlichen von dem Schutzgehäuse umschlossen und mit seinem Festende unmittelbar im Schutzgehäuse befestigt ist.

Die Erfindung geht dabei von der Überlegung aus, dass Beschädigungen des piezoeleketrischen Biegewandlers durch teilweise notwendig werdende mechanische Belastungen beim Transport und insbesondere bei der manuellen Montage auftre ten. Eine besonders hohe Beschädigungsgefahr besteht dabei beim Einsetzen und bei der Ausrichtung des Biegewandlers in einem Biegewandlermodul. Dabei muss der Biegewandler mit seinem Festende in dem Biegewandlermodul befestigt und zugleich mit seinem Tragkörper und dem Losende für eine einwandfreie Funktion korrekt ausgerichtet werden.

In einem weiteren Schritt geht die Erfindung von der Überlegung aus, dass eine Beschädigung des Biegewandlers durch eine mechanische Beanspruchung vermieden werden kann, wenn nicht der Biegewandler als solcher, sondern ein Biegewandlerelement aus einem Gehäuse und einem darin angeordneten Biegewandler transportiert und montiert wird. Dadurch, dass der Biegewandler im Wesentlichen von dem Schutzgehäuse umschlossen ist, ist er an sich vor äußeren mechanischen Einflüssen geschützt. Da weiter der Biegewandler mit seinem Festende unmittelbar im Schutzgehäuse befestigt ist, braucht bei einer Montage der Biegewandler als solcher auch nicht mehr ausgerichtet werden. Da seine Lage gegenüber dem Schutzgehäuse fixiert ist, muss für eine korrekte Positionierung des Biegewandlers in einem Biegewandlermodul ausschließlich das Schutzgehäuse gegenüber dem Biegewandlermodul justiert werden. Der Biegewandler selbst wird hierbei mechanisch nicht oder nur unmerklich belastet.

Mit anderen Worten sieht die Erfindung vor, einen Biegewandler mit einem ihn umgebenden Schutzgehäuse zu einer Baueinheit, nämlich einem Biegewandlerelement, zusammenzufassen. Das Schutzgehäuse schützt den darin angeordneten Biegewandler vor äußeren mechanischen Einflüssen. Eine Ausrichtung des Biegewandlers an seinem Einbauort wird ausschließlich durch eine Justierung des Schutzgehäuses vorgenommen.

Da bei einer Montage oder bei einem Austausch eines Biegewandlerelements die im Schutzgehäuse angeordneten Biegewandler selbst kaum oder gar nicht mechanisch belastet werden, wird durch die Erfindung die Beschädigungsquote während des Einbaus oder Austausches gegenüber der herkömmlichen Montage der Biegewandler direkt an einem Biegewandlermodul erheblich herabgesetzt. Auch während des Transports ist der Biegewandler vor äußeren Einflüssen sicher geschützt.

Für die notwendige mechanische Bewegbarkeit des Losendes des Biegewandlers kann das Schutzgehäuse entsprechend großzügig ausgestaltet sein. Insbesondere ist es vorstellbar, dass die Auslenkung des Losendes im Inneren des Gehäuses mechanisch abgegriffen wird. Auch im Falle eines Energiegenerators kann die Schwingung des Biegewandlers vollständig im Inneren des Gehäuses erfolgen. Der Biegewandler kann insofern komplett innerhalb des Schutzgehäuses angeordnet sein.

In einer vorteilhaften Ausgestaltung ist es vorgesehen, dass der Biegewandler mit seinem Losende beweglich aus einer Öffnung des Schutzgehäuses hervorsteht. Diese Ausgestaltung bietet sich insbesondere an, wenn das Losende des Biegewandlers mit mechanischen Kopplungselementen zur Übertragung der mechanischen Auslenkung zusammenwirkt. Ein frei liegendes Ende kann dabei leichter an weitere Wirkkomponenten mechanisch angekoppelt werden. Dies kann beispielsweise in Biegewandlermodulen zur Steuerung von Textilmaschinen der Fall sein, wobei die eingesetzten Biegewandler mit ihren jeweiligen Losenden mit Kopplungsgliedern zusammenwirken, die die mechanische Auslenkung der Biegewandlerenden beispielsweise zur Ansteuerung von Nadeln mechanisch übertragen und gegebenenfalls verstärken. Selbstverständlich kann das aus dem Schutzgehäuse ragende Losende des Biegewandlers auch als solches zu einer Übertragung von Informationen durch eine mechanische Auslenkung benutzt werden.

Weiter bevorzugt weist das Schutzgehäuse an der Öffnung seitliche Anschläge für das Losende auf. Durch diese seitlichen Anschläge wird die mechanische Auslenkung des Losendes seitlich begrenzt. Im Falle einer Informationsübertragung durch die Auslenkung des Losendes, das heißt einer gezielten elektrischen Ansteuerung der Biegewandler, sind durch die Anschläge definierte Endpositionen für das Losende geschaffen, denen eine definierte Information zugeordnet ist. Für einen Biegewandler, bei dem der Tragkörper beidseitig mit einer piezoelektrisch aktiven Beschichtung versehen ist, können insgesamt drei klar definierte Zustände des Losendes erzielt werden. In einer Ruheposition ist das Losende mittig in der Öffnung des Schutzgehäuses angeordnet. Die beiden anderen Zustände ergeben sich durch die jeweilige Anschlagsposition des Losendes an den beiden seitlichen Anschlägen.

Das Schutzgehäuse selbst kann mehrteilig oder einteilig angefertigt sein. Insbesondere ist es hierbei zweckmäßig, ein elektrisch nicht leitfähiges, isolierendes Material für das Schutzgehäuse zu verwenden. Dies kann beispielsweise ein Kunststoff und insbesondere ein glasfaserverstärkter Kunststoff (GFK) sein. Insbesondere eignet sich hierbei ein so genannter ABS-Kunststoff, das heißt ein Acryl-Nitril-Butadien-Styrol. Das Gehäuse kann insbesondere mittels Spritzguss hergestellt werden. Eine mehrteilige Ausgestaltung des Gehäuses bietet eine gewisse Erleichterung bei der Montage des Biegewandlers innerhalb des Schutzgehäuses.

In einer besonders günstigen Variante, die sowohl eine einfache Herstellung des Schutzgehäuses als auch eine einfache Montage des Biegewandlers bietet, besteht jedoch darin, das Schutzgehäuse einteilig zu fertigen und zu einer Einführung des Biegewandlers in seiner Längsrichtung zum Zwecke der Montage auszubilden. Bei der Montage wird demzufolge der Biegewandler in seiner Längsrichtung mit dem Festende voraus in das Schutzgehäuse eingeführt und am Festende fixiert. Eine Verklebung und/oder eine Verrastung von Gehäuseteilen nach oder während der Montage des Biegewandlers entfällt. Es muss lediglich ein einziges Spritzgussteil hergestellt werden. Da das Schutzgehäuse einen gewissen Bewegungsspielraum für den darin angeordneten Biegewandler erlauben muss, stellt das Einführen des Biegewandlers in das Schutzgehäuse einen relativ einfachen Montageschritt dar.

Zweckmäßigerweise ist das Festende des Biegewandlers formschlüssig im Schutzgehäuse fixiert. Bei einer solchen Ausgestaltung kann das Festende des in das Gehäuse eingeführten Biegewandlers in einfacher Art und Weise beispielsweise durch eine Verklemmung oder Verschraubung oder durch Verrastung fest mit dem Schutzgehäuse verbunden werden.

Hinsichtlich der Fixierung oder Befestigung des Biegewandlers in dem Schutzgehäuse ist es weiter vorteilhaft, wenn der Biegewandler an seinem Festende mit dem Schutzgehäuse verklebt ist. Durch einen solchen Materialschluss wird die Festigkeit der Verbindung weiter verbessert. In einer einfachen Art und Weise kann die Verklebung des Festendes mit dem Schutzgehäuse dann erfolgen, wenn das Schutzgehäuse an der Klebestelle eine Eindringöffnung für Klebstoff aufweist. Insbesondere bei einem einteiligen Schutzgehäuse erfolgt die Befestigung des Biegewandlers in dem Schutzgehäuse dann dadurch, dass der Biegewandler mit seinem Festende voraus an die Klebestelle innerhalb des Schutzgehäuses geführt wird, wo es beispielsweise durch einen entsprechenden Klemmkontakt bereits sicher gehalten wird. Über geeignete Einbringöffnungen kann dann an dieser Stelle der Klebstoff in das Innere des Schutzgehäuses eingeführt werden, so dass das Festende mit dem Schutzgehäuse fest verklebt. Da der Klebstoff im Inneren des Schutzgehäuses aushärten muss, empfiehlt es sich, einen UVhärtbaren Klebstoff zu verwenden. Durch eine entsprechende Bestrahlung - gegebenenfalls durch die Öffnungen hindurch - wird hierbei eine rasche und sichere Verklebung erzielt. Bei einem durch Sauerstoff härtenden Klebstoff wäre hiergegenüber gegebenenfalls die Aushärtezeit nachteiligerweise erhöht.

In einer weiteren vorteilhaften Ausgestaltung weist das Schutzgehäuse eine Anzahl von durch Stege getrennte Durchbrüche auf. Diese Ausgestaltung ist zum einen hinsichtlich einer Materialreduzierung des Schutzgehäuses von Vorteil. Die Anbringung von Durchbrüchen ist aber auch dann wünschenswert, wenn das Biegewandlerelement an Stellen eingesetzt wird, an denen es mit mechanischem Abrieb, Schmutz oder Staubpartikeln sowie Flüssigkeiten, wie insbesondere Öl oder sonstigen Schmiermitteln in Berührung kommt. Dies ist beispielsweise im Falle von Biegewandlermodulen der Fall, die zur Steuerung von Textilmaschinen eingesetzt sind. Durch die im Schutzgehäuse angeordneten Durchbrüche können solche Materialien durch das Schutzgehäuse wieder nach außen hindurchtreten, so dass die Funktionalität des Biegewandlers trotz entsprechend verschmutzter Umgebung erhalten bleibt. Hierzu bietet es sich insbesondere an, die Durchbrüche seitlich an dem Schutzgehäuse, das heißt quer zur Bewegungsrichtung des Biegewandlers anzuordnen. Durch die Bewegung des Biegewandlers reinigt sich das Schutzgehäuse gewissermaßen von selbst.

Zur elektrischen Kontaktierung des Biegewandlers ist bevorzugterweise an seinem Festende im Schutzgehäuse ein elektrischer Steckkontakt angeordnet, über den ein externer Anschluss an eine entsprechende Steuerleitung möglich ist. In einer besonders bevorzugten Ausgestaltung ist hierbei der Steckkontakt aus einem leitfähigen Elastomer gebildet, gegen den entsprechende Kontaktstellen des Biegewandlers in seinem endmontierten Zustand im Schutzgehäuse gedrückt sind. Dabei können insbesondere die Kontaktflächen der piezoelektrischen Beschichtung selbst direkt mit dem elektrischen Steckkontakt, das heißt insbesondere direkt mit dem leitfähigen Elastomer, kontaktiert sein. Alternativ sind auf dem zu kontaktierenden Festende des Tragkörpers leitfähige Pads, beispielsweise aus Kupfer, angeordnet, die mit den Kontaktflächen oder Elektroden der piezoelektrisch aktiven Beschichtung leitend verbunden sind.

Für eine externe Kontaktierungsmöglichkeit des Steckkontaktes und insbesondere des leitfähigen Elastomers sind zweckmäßigerweise im Schutzgehäuse eine Anzahl von Bohrungen eingebracht. Über diese Bohrungen können dann Kontaktstifte oder dergleichen über den Steckkontakt mit den Elektroden oder Kontaktflächen des Biegewandlers elektrisch verbunden werden. Im Falle eines leitfähigen Elastomers als Steckkontakt ist es zur Herstellung einer elektrisch leitfähigen Verbindung mit den Elektroden oder Kontaktflächen des Biegewandlers lediglich notwendig, Kontaktstifte in das Elastomer einzuführen.

Da das Schutzgehäuse mit dem darin fixierten Biegewandler als Ganzes ein montage- und transportfähiges Biegewandlerelement darstellt, empfiehlt es sich, das Schutzgehäuse einer Einbaujustage endseitig mit Stiften zu versehen. Mittels geeignet angebrachter Ausnehmungen an dem Gegenstück, an welchem das Biegewandlerelement zu befestigen ist, kann eine leichte Ausrichtung des Biegewandlerelements und damit des Biegewandlers erzielt werden. Zweckmäßigerweise weist das Schutzgehäuse als eine Aus-/Einbauhilfe ein U-förmiges Aufnahmeelement auf, welches eine Eingriffsöffnung für ein Werkzeug umfasst. In die Eingriffsöffnung kann leicht das Werkzeug, wie beispielsweise ein Schraubendreher oder dergleichen eingeführt werden, wodurch sich sowohl der Einbau als auch der Ausbau des Biegewandlerelements vereinfacht.

In einer vorteilhaften Ausgestaltung als Energiegenerator ist an dem Losende des aus dem Schutzgehäuse ragenden Biegewandlers ein Masseelement befestigt. Eine mechanische Erschütterung oder eine Vibration des Biegewandlerelements führt dann aufgrund der vergrößerten Schwingmasse zu einer mechanischen Auslenkung des Biegewandlers. Hierdurch wird zwischen den Elektroden der piezoelektrischen Beschichtung eine Spannung erzeugt, die beispielsweise über die vorgenannte Kontaktierung abgegriffen und zur Energieversorgung bereitgestellt werden kann. Bei dieser Ausgestaltung sind die seitlichen Anschläge des Schutzgehäuses insbesondere auch deshalb sinnvoll, weil hierdurch eine zu weite Auslenkung des Biegewandlers und somit eine Beschädigung der piezoelektrischen Beschichtung sicher vermieden ist.

Eine solche Ausgestaltung des Biegewandlerelements bietet sich insbesondere für den Einsatz als Energielieferant für eine Messelektronik an, die auf herkömmliche Weise mit elektrischen Leitern beziehungsweise Kabeln nicht kontaktiert werden kann. Eine solche Messelektronik ist beispielsweise ein Reifensensor, der auf der Felge eines Laufrads eines Kraftfahrzeugs montiert ist. Dieser aufgrund der beständigen Rotation nur aufwändig elektrisch kontaktierbare Reifensensor erfasst beispielsweise den Reifendruck oder einen sonstigen Zustandsparameter und sendet das Messergebnis per Funk an die Bordelektronik des Kraftfahrzeugs. Zur elektrischen Versorgung eines solchen Reifensensors bietet es sich an, das geschilderte Biegewandlerelement mit einem dem Losende aufgesetzten Masseelement mit auf dem Laufrad zu positionieren. Durch die beständige Bewegung und Erschütterung des Laufrads steht für den Reifensensor ausreichend Energie zur Aufnahme der Messwerte und zur Absendung per Funk zur Verfügung.

Die zweitgenannte Aufgabe wird erfindungsgemäß durch ein Biegewandlermodul gelöst, welches eine Mehrzahl der vorgenannten Biegewandlerelemente umfasst, wobei die Biegewandlerelemente an einer Flachbaugruppe zusammengefasst sind. Insbesondere sind dabei die Biegewandlerelemente parallel nebeneinander angeordnet.

Wie bereits erwähnt ist der Einbau eines Biegewandlermoduls im Zuge einer Neumontage oder eines Austauschs an der Flachbaugruppe mit keiner oder allenfalls einer geringen mechanischen Belastung des Biegewandlers verbunden. Es wird stets das gesamte Biegewandlerelement, das heißt im Grunde genommen das Schutzgehäuse mit dem darin angeordneten Biegewandler eingesetzt. Ein direkter mechanischer Kontakt mit dem Biegewandler als solchem ist dabei sicher verhindert.

In einer bevorzugten Ausgestaltung des Biegewandlermoduls weist die Flachbaugruppe Kontaktstifte auf, die mit den elektrischen Steckkontakten der Biegewandlerelemente in Verbindung stehen. Auf diese Weise vereinfacht sich die Montage der Biegewandlerelemente an der Flachbaugruppe weiter erheblich, da zur elektrischen Kontaktierung die Schutzgehäuse mit entsprechenden Bohrungen einfach auf die Kontaktstifte aufgesetzt werden. Sind die Steckkontakte der Biegewandlerelemente in Form eines leitfähigen Elastomers ausgestaltet, werden die Biegewandlerelemente schlichtweg einfach den Kontaktstiften aufgesetzt.

Zur Montage und Ausrichtung der Biegewandlerelemente sind die am Schutzgehäuse angeordneten Stifte vorgesehen, diese Stifte wechselwirken mit entsprechenden Ausnehmungen, die in einem Modulgehäuse angeordnet sind, in welchem sowohl die Flachbaugruppe als auch die Biegewandlerelemente angeordnet sind.

Die Flachbaugruppe selbst ist beispielsweise als ein Kunststoffteil ausgestaltet, auf welchem sowohl die Elektronik als auch die damit verbundenen Kontaktstifte angeordnet sind.

Ein Biegewandlermodul der vorbeschriebenen Art eignet sich insbesondere als ein Steuermodul zur Steuerung von Textilmaschinen. Dabei wird - wie bereits erwähnt - die mechanische Auslenkung der Losenden der Biegewandler zur Informationsübertragung genutzt, ob eine Masche gebildet werden soll oder nicht.

Die weiter zu dem Biegewandlerelement vorbeschriebenen Vorteile können sinngemäß auf das Biegewandlermodul, in welchem eine Mehrzahl der Biegewandlerelemente eingesetzt ist, übertragen werden.

Ausführungsbeispiele der Erfindung sind anhand einer Zeichnung näher erläutert. Dabei zeigen jeweils in perspektivischer Darstellung:
- Fig. 1: ein Biegewandlerelement mit einem Schutzgehäuse und einem darin angeordneten Biegewandler,
- Fig. 2: in einer Explosionsdarstellung ein Biegewandlermodul mit einer Flachbaugruppe und einer Mehrzahl von Biegewandlerelementen gemäß Fig. 1,
- Fig. 3: in einer Explosionsdarstellung ein weiteres Biegewandlerelement, welches als Energiegenerator ausgelegt ist, und
- Fig. 4: das Biegewandlerelement gemäß Fig. 3 in seinem zusammengebau- ten Zustand.

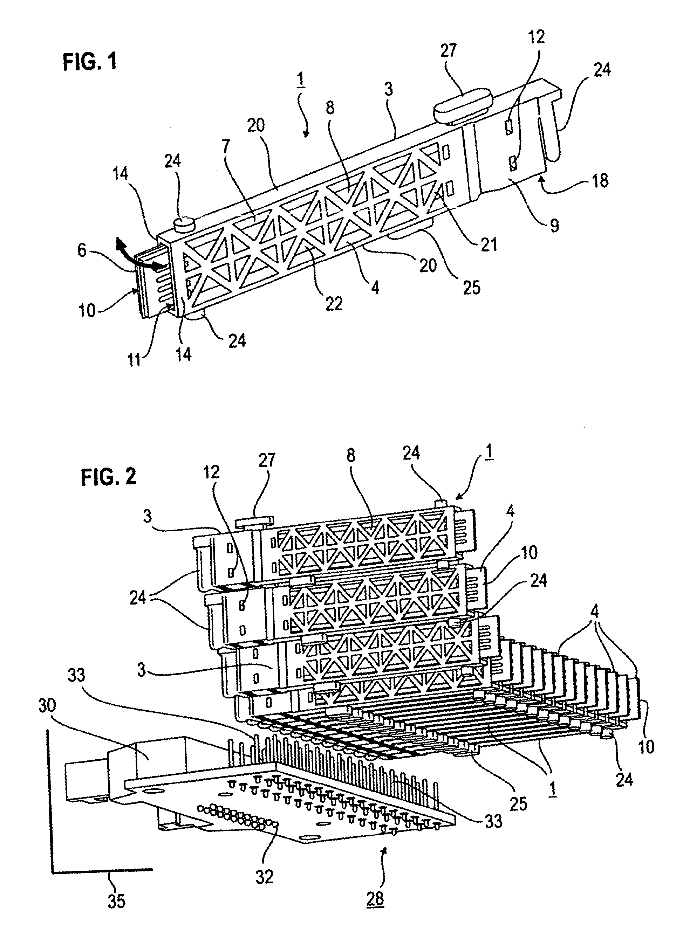

Fig. 1 zeigt in einer perspektivischen Darstellung ein Biegewandlerelement 1, welches ein Schutzgehäuse 3 und einen im Schutzgehäuse 3 angeordneten Biegewandler 4 umfasst. Der in dem Gehäuse 3 angeordnete Biegewandler 4 weist einen flachen Tragkörper 6 auf, der beidseitig jeweils mit einer piezoelektrisch aktiven Beschichtung 7 versehen ist. Der Biegewandler 4 ist mit seinem Festende 9 im Inneren des Schutzgehäuses 3 fixiert. An einer Öffnung 11 des Schutzgehäuses 3 ragt ein Losende 10 des Biegewandlers 4 heraus, der in den durch Pfeile angedeuteten Richtungen bewegbar ist.

Das Schutzgehäuse 3 ist als ein einstückiges Spritzgussteil aus einem glasfaserverstärkten ABS-Kunststoff gefertigt. Zur Montage wird der Biegewandler 4 ausgehend von der Öffnung 11 mit dem Festende 9 voraus in das Innere des Schutzgehäuses 3 geführt. Am Ende des Schutzgehäuses 3 ist im Inneren eine Klemmaufnahme für das Losende 10 des Biegewandlers 4 eingeformt. Ist der Biegewandler 4 mit seinem Losende 10 in dieser Klemmaufnahme fixiert, so wird über die Einbringöffnungen 12 Klebstoff in das Innere des Schutzgehäuses 3 eingebracht, wodurch der Biegewandler 4 mit seinem Festende zusätzlich zum Formschluss materialschlüssig mit dem Schutzgehäuse 3 verbunden wird. Hierdurch wird eine besonders sichere und haltbare Verbindung zwischen dem Biegewandler 4 und dem Schutzgehäuse 3 erzielt.

An der Öffnung 11 des Schutzgehäuses 3 sind seitlich Anschläge 14 vorgesehen, wodurch zum einen eine erhöhte mechanische Belastung des Biegewandlers 4 durch eine unachtsame Auslenkung vermieden und zum anderen definierte Stellpositionen des Losendes 10 erzielt werden. Am anderen Ende des Schutzgehäuses 3 ist, hier nicht sichtbar, ein Steckkontakt 18 angeordnet, der ein leitfähiges Elastomer umfasst, gegen welches im Einbauzustand die Kontaktflächen 8 der piezoelektrisch aktiven Beschichtung 7 gedrückt und somit leitfähig verbunden sind. Über entsprechende Bohrungen in dem Schutzgehäuse 3 kann dann leicht eine elektrische Kontaktierung der Kontaktflächen 8 mit externen Anschlüssen erfolgen.

Das Schutzgehäuse 3 weist weiter sich oberhalb und unterhalb des Tragkörpers 6 des Biegewandlers 4 erstreckende durchgehende Leisten 20 auf. Die den Biegewandler 4 umgebenden Seitenflächen des Schutzgehäuses 3 sind durch Stege 21 mit dazwischen angeordneten Durchbrüchen 22 versehen. Über diese Durchbrüche 22 treten Verunreinigungen wie Schmutz- oder Staubpartikel sowie Schmiermittel oder dergleichen infolge der Bewegungen des Biegewandlers 4 aus, so dass die Funktionsfähigkeit des Biegewandlerelements 1 auch in Umgebungen mit erhöhter Schmutzbelastung erhalten bleibt.

Weiter sind an dem Schutzgehäuse 3 beidendseitig Stifte 24 vorgesehen, die einer Ausrichtung in einem etwaigen Biegewandlermodul-Gehäuse dienen. Zu einer solchen Ausrichtung oder Positionierung ist weiter an der Unterseite des Schutzgehäuses 3 ein Justagesteg 25 angeordnet, der an eine entsprechend geformte Ausnehmung an einem Biegewandlermodul-Gehäuse oder dergleichen eingreift. An der Oberseite des Schutzgehäuses 3 ist ferner ein Aufnahmeelement 27 angeordnet, welches eine Aufnahmeöffnung für ein geeignetes Werkzeug, wie insbesondere einen Schraubendreher, umfasst. Durch Einführung des Werkzeugs in die Öffnung des Aufnahmeelements 27 kann das montierte Biegewandlerelement 1 leicht entfernt und somit ausgetauscht werden.

In Fig. 2 ist in einer Explosionsdarstellung ein Biegewandlermodul 28 mit seinen wesentlichsten Teilen dargestellt. In dem Biegewandlermodul 28 sind eine Mehrzahl von Biegewandlerelementen 1 parallel nebeneinander angeordnet. Jedes einzelne Biegewandlermodul 28 trägt dabei insgesamt sechzehn Biegewandlerelemente 1. Man erkennt die Flachbaugruppe 30 zur Aufnahme der Biegewandlerelemente 1, die eine Elektronikschaltung 32 zur Ansteuerung der Biegewandler 4 sowie Kontaktstifte 33 zu einer elektrischen Kontaktierung trägt.

Das dargestellte Biegewandlermodul 28 eignet sich insbesondere zur Ansteuerung der Nadeln einer Textilmaschine. Durch die jeweilige Auslenkposition der Losenden 10 der Biegewandler 4 wird die für die Textilmaschine zur Musterbildung erforderliche Information weitergegeben. Dabei können die Losenden 10 gegebenenfalls mit mechanischen Übertragungsmitteln verbunden sein.

Zur elektrischen Kontaktierung werden die jeweiligen Biegewandlerelemente 1 als Einheit mit ihren den Losenden 10 abgewandten Enden auf die entsprechenden Kontaktstifte 33 der Flachbaugruppe 30 aufgesetzt. In den Schutzgehäusen 3 der Biegewandlerelemente 1 sind dabei jeweils entsprechende Bohrungen zur Aufnahme der Kontaktstifte 33 eingebracht. Die Kontaktstifte 33 dringen dabei über die Bohrungen in ein leitfähiges Elastomer ein, wodurch eine elektrische Kontaktierung mit den Kontaktflächen 8 der piezoelektrischen Biegewandler 4 hergestellt wird. Wie erwähnt sind die Kontaktflächen 8 gegen die im hinteren Ende der Schutzgehäuse 3 eingesetzten leitfähigen Elastomere gedrückt.

Sowohl die Flachbaugruppe 30 als auch die Biegewandlerelemente 1 sind insgesamt in einem lediglich schematisch gezeigten Modulgehäuse 35 angeordnet. Aus diesem Modulgehäuse 35 sind beispielsweise die elektrischen Anschlusskabel sowie Versorgungsleitungen etc. herausgeführt.

Weiter ist das Modulgehäuse 35 so gestaltet, dass die der Flachbaugruppe30 aufzusetzenden Biegewandlerelemente 1 mit den am Schutzgehäuse 3 jeweils angeordneten Stiften 24 und Justagestegen 25 in entsprechende Ausnehmungen eingreifen, wodurch eine gewünschte Ausrichtung im Montageendzustand erreicht wird. Dies ermöglicht eine besonders einfache und sichere Montage. Eine direkte mechanische Belastung der Biegewandler 4 ist durch den Kompletteinbau der Biegewandlerelemente 1 nicht gegeben. Die Beschädigungsquote von Biegewandlern 4 bei der Montage des Biegewandlermoduls 28 oder bei einem Ersatz defekter Biegewandlerelemente 1 durch neue Biegewandlerelemente 1 ist gegenüber den bekannten Lösungen des Standes der Technik, wobei die Biegewandler 4 als solche in das Biegewandlermodul 28 bzw. in das entsprechende Modulgehäuse 35 eingesetzt werden, ist deutlich herabgesetzt.

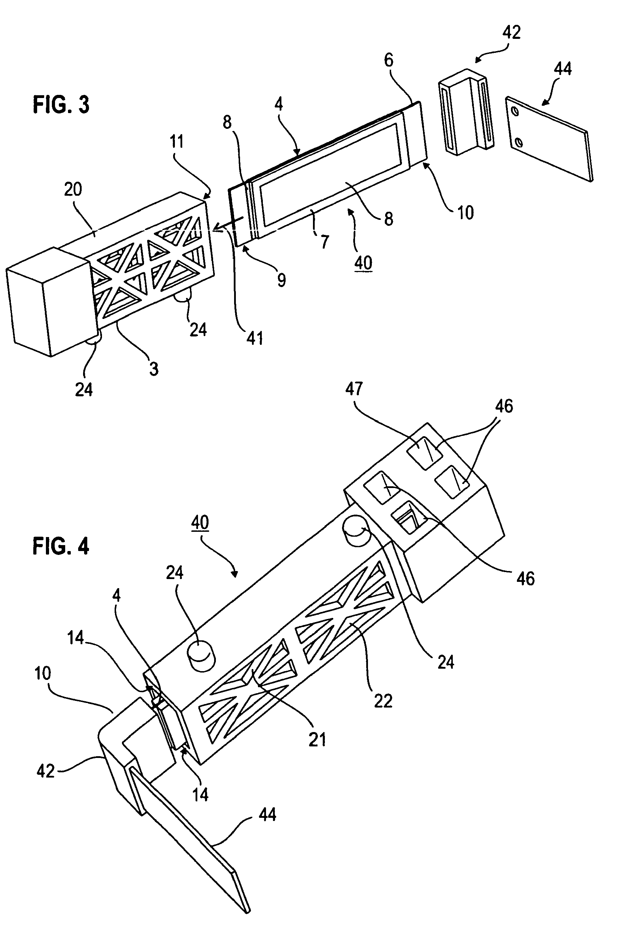

In Fig. 3 ist in einer Explosionsdarstellung ein als Energielieferant ausgestaltetes alternatives Biegewandlerelement 40 gezeigt. Auch das Biegewandlerelement 40 weist die grundlegenden Bauelemente entsprechend dem Biegewandlerelement 1 gemäß Fig. 1 auf. So umfasst das Biegewandlerelement40 ein Schutzgehäuse 3, in welchem ein Biegewandler 4 angeordnet ist. Auch der in Fig. 3 gezeigte Biegewandler 4 umfasst einen flachen Tragkörper 6 mit einer darauf beidseitig aufgebrachten piezoelektrisch aktiven Beschichtung 7. Auf der piezoelektrisch aktiven Beschichtung 7 sind jeweils eine äußere und eine innere Kontaktfläche 8 aufgebracht.

Zur Montage wird der Biegewandler4 mit seinem Festende 9 voran in Richtung seiner Längsrichtung 41 in das Schutzgehäuse 3 eingeführt. An dem Ende des Schutzgehäuses 3 wird das Festende 9 des Biegewandlers 4 wiederum mit einer Klemmvorrichtung gehalten und über Klebstoff fest an das Schutzgehäuse3 angebunden.

An dem aus dem Schutzgehäuse 3 wiederum herausragenden Losende 10 des Biegewandlers 4 ist ein rechtwinklig abgeknicktes Verbindungselement 42 aufgesetzt, an welchem ein aus Metall bestehendes Masseelement 44 eingesetzt ist. Über das Masseelement 44 wird eine Erschütterung oder Vibration der Umgebung in eine Auslenkung des Losendes 10 des Biegewandlers 4 umgesetzt. Infolge der Auslenkung des Biegewandlers 4 und der darauf aufgebrachten piezoelektrisch aktiven Beschichtung 7 wird eine Spannung zwischen den Kontaktflächen 8 generiert, die über eine entsprechende Kontaktierung abgegriffen und als Energie - wo benötigt - zur Verfügung gestellt wird.

Zur Montage und Ausrichtung des in Fig. 3 gezeigten Biegewandlerelements 40 weist das Schutzgehäuse 3 wiederum beidendseitig Stifte 24 auf. Diese können in entsprechende Ausnehmungen an der Montagestelle gesteckt werden, wodurch die Ausrichtung des Biegewandlerelements 1 erfolgt.

In Fig.4 ist das in Fig. 3 dargestellte Biegewandlerelement 40 im zusammengebauten Zustand dargestellt.

Man erkennt nun, wie an dem Losende 10 des Biegewandlers 4 mittels des Verbindungselements 42 das Masseelement 44 angeordnet ist. Um eine zu große Auslenkung des Losendes 10 aufgrund mechanischer Erschütterungen oder dergleichen zu vermeiden, sind an dem Schutzgehäuse 3 seitliche Anschläge 14 angebracht.

Auch die Seitenflächen des Schutzgehäuses 3 des Biegewandlerelements 40 weisen durch Stege 21 voneinander getrennte Durchbrüche 22 auf. Am dem Losende 10 abgewandten Ende des Schutzgehäuses 3 werden die Bohrungen 46 ersichtlich, über die eine elektrische Kontaktierung mit den Kontaktflächen 8 des Biegewandlers 4 ermöglicht ist. In diese Bohrungen 46 wird jeweils ein leitfähiges Elastomer 47 eingefügt, gegen welches sich im Einbauzustand die jeweiligen Kontaktflächen 8 des Biegewandlers4 abstützen. Über eine einfache Steckkontaktierung durch Einführen eines Kontaktstiftes in das jeweils leitfähige Elastomer47 wird eine einfache elektrische Kontaktierung des Biegewandlers 4 mit externen Anschlüssen erzielt.

Das in den Fig. 3 und 4 dargestellte Biegewandlerelement 40 eignet sich insbesondere als Energielieferant für eine Messelektronik an rotierenden oder beweglichen Teilen. Insbesondere kann dies ein Reifensensor sein, der an einer Felge eines Laufrads eines Kraftfahrzeugs montiert ist. Mit auf der Felge wird das Biegewandlerelement 40 montiert. Durch die beständigen Erschütterungen und Vibrationen sowie Rotationen des Laufrads erzeugt das Biegewandlerelement 40 genügend Energie für den Reifensensor zur Aufnahme von Messwerten und zur Weiterleitung mittels Funk an eine entsprechende Bordelektronik.

### Bezugszeichenliste

- 1: Biegewandlerelement
- 3: Schutzgehäuse
- 4: Biegewandler
- 6: Tragkörper
- 7: piezoelektrisch aktive Beschichtung
- 8: Kontaktfläche
- 9: Festende
- 11: Öffnung
- 10: Losende
- 12: Einbringöffnungen
- 14: Anschläge
- 18: Steckkontakt
- 20: Leisten
- 21: Stege
- 22: Durchbrüche
- 24: Stifte
- 25: Justagesteg
- 27: Aufnahmeelement
- 28: Biegewandlermodul
- 30: Flachbaugruppe
- 32: Elektronikschaltung
- 33: Kontaktstifte
- 35: Modulgehäuse
- 40: Biegewandlerelement
- 41: Längsrichtung
- 42: Verbindungselement
- 44: Masseelement
- 46: Bohrungen
- 47: Elastomer

## Patentansprüche

1. Biegewandlerelement (1,40) mit einem Biegewandler (4), umfassend einen flachen Tragkörper (6) und eine darauf auf mindestens einer Seite aufgebrachten piezoelektrisch aktiven Beschichtung (7), **dadurch gekennzeichnet, dass** das Biegewandlerelement (1, 40) ein Schützgehäuse (3) aufweist, in dem der Biegewandler (4) angeordnet ist, wobei der Biegewandler (4) im wesentlichen von dem Schutzgehäuse (3) umschlossen und mit seinem Festende (9) unmittelbar im Schutzgehäuse (3) befestigt ist.

2. Biegewandlerelement (1,40) nach Anspruch 1,
**dadurch gekennzeichnet,**
**dass** der Biegewandler (4) mit seinem Losende (10) beweglich aus einer Öffnung (11) des Schutzgehäuses (3) hervorsteht.

3. Biegewandlerelement (1,40) nach Anspruch 1 oder 2,
**dadurch gekennzeichnet,**
**dass** das Schutzgehäuse (3) an der Öffnung (11) seitliche Anschläge (14) für das Losende (10) aufweist.

4. Biegewandlerelement (1,40) nach einem der vorhergehenden Ansprüche,
**dadurch gekennzeichnet,**
**dass** das Schutzgehäuse (3) einteilig gefertigt und zu einer Einführung des Biegewandlers (4) in seiner Längsrichtung (41) zum Zwecke der Montage ausgebildet ist.

5. Biegewandlerelement (1,40) nach einem der vorhergehenden Ansprüche,
**dadurch gekennzeichnet,**
**dass** das Festende (9) des Biegewandlers (4) formschlüssig im Schutzgehäuse (3) fixiert ist.

6. Biegewandlerelement (1,40) nach einem der vorhergehenden Ansprüche,
**dadurch gekennzeichnet,**
**dass** der Biegewandler (4) an seinem Festende (9) mit dem Schutzgehäuse (3) verklebt ist

7. Biegewandlerelement (1,40) nach Anspruch 6,
**dadurch gekennzeichnet,**
**dass** das Schutzgehäuse (3) an der Klebestelle eine Einbringöffnung (12) für Klebstoff aufweist.

8. Biegewandlerelement (1,40) nach Anspruch 6 oder 7,
**dadurch gekennzeichnet,**
**dass** der Biegewandler (3) an seinem Festende (9) über einen UVhärtbaren Klebstoff verklebt ist.

9. Biegewandlerelement (1,40) nach einem der vorhergehenden Ansprüche,
**dadurch gekennzeichnet,**
**dass** das Schutzgehäuse (3) eine Anzahl von durch Stege (21) getrennte Durchbrüche (22) aufweist.

10. Biegewandlerelement (1,40) nach einem der vorhergehenden Ansprüche,
**dadurch gekennzeichnet,**
**dass** zur Kontaktierung des Biegewandlers (3) an seinem Festende (9) im Schutzgehäuse (3) ein elektrischer Steckkontakt, insbesondere gebildet aus einem leitfähigen Elastomer (47), angeordnet ist.

11. Biegewandlerelement (1,40) nach Anspruch 10,
**dadurch gekennzeichnet,**
**dass** der Biegewandler (3) über eine Kontaktfläche direkt mit dem elektrischen Steckkontakt kontaktiert ist.

12. Biegewandlerelement (1,40) nach Anspruch 10 oder 11,
**dadurch gekennzeichnet,**
**dass** das Schutzgehäuse (3) eine Anzahl von Bohrungen (46) für eine Kontaktierung des Steckkontaktes, insbesondere des leitfähigen Elastomers (47), mit externen Anschlüssen aufweist.

13. Biegewandlerelement (1,40) nach einem der vorhergehenden Ansprüche,
**dadurch gekennzeichnet,**
**dass** das Schutzgehäuse (3) zu einer Einbaujustage beidendseitig angeordnete Stifte (24) aufweist.

14. Biegewandlerelement (1,40) nach einem der vorhergehenden Ansprüche,
**dadurch gekennzeichnet,**
**dass** das Schutzgehäuse (3) als eine Aus-/Einbauhilfe ein U-förmiges Aufnahmeelement (27) mit einer Eingriffsöffnung für ein Werkzeug aufweist.

15. Biegewandlerelement (1,40) nach einem der vorhergehenden Ansprüche,
**dadurch gekennzeichnet,**
**dass** am Losende (9) des Biegewandlers (4) ein Masseelement (44) befestigt ist.

16. Biegewandlermodul (28) umfassend eine Mehrzahl von Biegewandlerelementen (1) gemäß einem der vorhergehenden Ansprüche, wobei die Biegewandlerelemente (1) an einer Flachbaugruppe (32) zusammengefasst sind.

17. Biegewandlermodul (28) nach Anspruch 16,
**dadurch gekennzeichnet,**
**dass** die Flachbaugruppe (32) Kontaktstifte (33) aufweist, die mit den elektrischen Steckkontakten der Biegewandlerelemente (1) in Verbindung stehen.

18. Biegewandlermodul (28) nach Anspruch 16 oder 17,
**dadurch gekennzeichnet,**
**dass** die Flachbaugruppe (32) in einem Modulgehäuse (35) fixiert ist.

19. Biegewandlermodul (28) nach Anspruch 18,
**dadurch gekennzeichnet,**
**dass** die Biegewandlerelemente (1) jeweils über die an den Schutzgehäusen (3) angeordneten Stifte (24) im Modulgehäuse (35) ausgerichtet sind.

## Claims

1. A bending actuator element (1,40) having a bending actuator (4), comprising a flat supporting body (6) and a piezoelectrically active coating (7) applied thereon on at least one side, **characterised in that** the bending actuator element (1,40) has a protective housing (3) in which the bending actuator (4) is arranged, wherein the bending actuator (4) is substantially enclosed by the protective housing (3) and is secured with its fixed end (9) directly in the protective housing (3).

2. A bending actuator element (1,40) according to claim 1,
**characterised in that**
the bending actuator (4) protrudes with its loose end (10) in a movable manner out of an opening (11) of the protective housing (3).

3. A bending actuator element (1,40) according to claim 1 or 2,
**characterised in that**
the protective housing (3) has at the opening (11) lateral stops (14) for the loose end (10).

4. A bending actuator element (1,40) according to one of the preceding claims,
**characterised in that**
the protective housing (3) is produced in one piece and is formed, for the purposes of assembly, for insertion of the bending actuator (4) in its longitudinal direction (41).

5. A bending actuator element (1,40) according to one of the preceding claims,
**characterised in that**
the fixed end (9) of the bending actuator (4) is fixed in the protective housing (3) in a form-locking manner.

6. A bending actuator element (1,40) according to one of the preceding claims,
**characterised in that**
the bending actuator (4) is glued at its fixed end (9) to the protective housing (3).

7. A bending actuator element (1,40) according to claim 6,
**characterised in that**
the protective housing (3) has at the gluing point an opening (12) for introduction of glue.

8. A bending actuator element (1,40) according to claim 6 or 7,
**characterised in that**
the bending actuator (3) is glued at its fixed end (9) by way of a UV-hardenable glue.

9. A bending actuator element (1,40) according to one of the preceding claims,
**characterised in that**
the protective housing (3) has a number of breakthroughs (22) that are separated by webs (21).

10. A bending actuator element (1,40) according to one of the preceding claims,
**characterised in that**
in order to contact the bending actuator (3) at its fixed end (9) in the protective housing (3) there is provided an electrical plug contact, formed in particular from a conductive elastomer (47).

11. A bending actuator element (1,40) according to claim 10,
**characterised in that**
the bending actuator (3) is contacted by way of a contact face directly with the electrical plug contact.

12. A bending actuator element (1,40) according to claim 10 or 11,
**characterised in that**
the protective housing (3) has a number of bores (46) for contacting the plug contact, in particular the conductive elastomer (47), with external terminals.

13. A bending actuator element (1,40) according to one of the preceding claims,
**characterised in that**
the protective housing (3) for installation-adjustment has pins (24) that are arranged on both end sides.

14. A bending actuator element (1,40) according to one of the preceding claims,
**characterised in that**
the protective housing (3) has as a removal/installation aid a U-shaped receiving element (27) with an opening for engagement of a tool.

15. A bending actuator element (1,40) according to one of the preceding claims,
**characterised in that**
secured to the loose end (9) of the bending actuator (4) there is a mass element (44).

16. A bending actuator module (28) comprising a plurality of bending actuator elements (1) according to one of the preceding claims, wherein the bending actuator elements (1) are combined on a flat assembly (32).

17. A bending actuator module (28) according to claim 16,
**characterised in that**
the flat assembly (32) has contact pins (33) which communicate with the electrical plug contacts of the bending actuator elements (1).

18. A bending actuator module (28) according to claim 16 or 17,
**characterised in that**
the flat assembly (32) is fixed in a module housing (35).

19. A bending actuator module (28) according to claim 18,
**characterised in that**
the bending actuator elements (1) are each aligned in the module housing (35) by way of the pins (24) that are arranged on the protective housings (3).

## Revendications

1. Elément (1, 40) convertisseur de flexion ayant un convertisseur (4) de flexion, comprenant un corps (6) plat de support et un revêtement (7) actif du point de vue piézoélectrique et déposé sur au moins une face,
**caractérisé**
**en ce que** l'élément (1, 40) convertisseur de flexion comporte un boîtier (3) de protection, dans lequel le convertisseur (4) de flexion est disposé, le convertisseur (4) de flexion étant entouré sensiblement par le boîtier (3) de protection et étant fixé par son extrémité (9) fixe directement dans le boîtier (3) de protection.

2. Elément (1, 40) convertisseur de flexion suivant la revendication 1,
**caractérisé**
**en ce que** le convertisseur (4) de flexion dépasse par son extrémité (10) lâche de manière mobile d'une ouverture (11) du boîtier (3) de protection.

3. Elément (1, 40) convertisseur de flexion suivant la revendication 1 ou 2,
**caractérisé**
**en ce que** le boîtier (3) de protection a sur l'ouverture (11) des butées (14) latérales pour l'extrémité (10) lâche.

4. Elément (1, 40) convertisseur de flexion suivant l'une des revendications précédentes,
**caractérisé**
**en ce que** le boîtier (3) de protection est fabriqué en une seule pièce et est constitué pour une introduction du convertisseur (4) de flexion dans sa direction (41) longitudinale en vue du montage.

5. Elément (1, 40) convertisseur de flexion suivant l'une des revendications précédentes,
**caractérisé**
**en ce que** l'extrémité (9) fixe du convertisseur (4) de flexion est immobilisée à complémentarité de forme dans le boîtier (3) de protection.

6. Elément (1, 40) convertisseur de flexion suivant l'une des revendications précédentes,
**caractérisé**
**en ce que** le convertisseur (4) de flexion est collé à son extrémité (9) fixe au boîtier (3) de protection.

7. Elément (1, 40) convertisseur de flexion suivant la revendication 6,
**caractérisé**
**en ce que** le boîtier (3) de protection a au point de collage une ouverture (12) d'entrée de colle.

8. Elément (1, 40) convertisseur de flexion suivant la revendication 6 ou 7,
**caractérisé**
**en ce que** le convertisseur (3) de flexion est collé à son extrémité (9) fixe par une colle durcissable aux UV.

9. Elément (1, 40) convertisseur de flexion suivant l'une des revendications précédentes,
**caractérisé**
**en ce que** le boîtier (3) de protection a un certain nombre de traversées (22) séparées par des parties (21) pleines.

10. Elément (1, 40) convertisseur de flexion suivant l'une des revendications précédentes,
**caractérisé**
**en ce que**, pour la mise en contact du convertisseur (3) de flexion, il est disposé à son extrémité (9) fixe dans le boîtier (3) de protection un contact électrique par enfichage, notamment en un élastomère (47) conducteur.

11. Elément (1, 40) convertisseur de flexion suivant la revendication 10,
**caractérisé**
**en ce que** le convertisseur (3) de flexion est mis en contact par une surface de contact directement avec le contact électrique par enfichage.

12. Elément (1, 40) convertisseur de flexion suivant la revendication 10 ou 11,
**caractérisé**
**en ce que** le boîtier (3) de protection comporte un certain nombre de trous (46) pour une mise en contact du contact par enfichage, notamment de l'élastomère (47) conducteur avec des bornes extérieures.

13. Elément (1, 40) convertisseur de flexion suivant l'une des revendications précédentes,
**caractérisé**
**en ce que** le boîtier (3) de protection comporte des broches (24) disposées des deux côtés par rapport à un ajustage de montage.

14. Elément (1, 40) convertisseur de flexion suivant l'une des revendications précédentes,
**caractérisé**
**en ce que** le boîtier (3) de protection comporte sous la forme d'une aide au démontage/montage un élément (27) en forme de U de réception ayant une ouverture de pénétration d'un outil.

15. Elément (1, 40) convertisseur de flexion suivant l'une des revendications précédentes,
**caractérisé**
**en ce qu'**un élément (44) formant masselotte est fixé à l'extrémité (9) lâche du convertisseur (4) de flexion.

16. Module (28) de convertisseur de flexion, comprenant une multiplicité d'éléments (1) de convertisseur de flexion suivant l'une des revendications précédentes, les éléments (1) convertisseurs de flexion étant rassemblés sur un module (32) plat.

17. Module (28) de convertisseur de flexion suivant la revendication 16,
**caractérisé**
**en ce que** le module (32) plat a des broches (33) de contact, qui sont en liaison avec les contacts électriques par enfichage des éléments (1) de convertisseur de flexion.

18. Module (28) de convertisseur de flexion suivant la revendication 16 ou 17,
**caractérisé**
**en ce que** le module (32) plat est immobilisé dans un boîtier (35) de module.

19. Module (28) de convertisseur de flexion suivant la revendication 18,
**caractérisé**
**en ce que** les éléments (1) convertisseurs de flexion sont orientés dans le boîtier (35) de module respectivement par les broches (24) disposées sur le boîtier (3) de protection.
